# EUROPÄISCHE PATENTANMELDUNG

(11) **EP 4 783 221 A1**
(43) Veröffentlichungstag der Anmeldung: **29.07.2026**
(21) Anmeldenummer: 25153583.7
(22) Anmeldetag: 23.01.2025
(51) Int. Cl.: H01J 37/20

(54) **PROBENHALTER FÜR EIN ELEKTRONENMIKROSKOP, SYSTEM UND VERFAHREN**

(71) Anmelder: Forschungszentrum Jülich GmbH, 52428 Jülich (DE)
(72) Erfinder: SCHAAF, Michael, 52134 Herzogenrath (DE); ZINGSEM,, Dr. Benjamin, 41169 Mönchengladbach (DE); DUNIN-BORKOWSKI, Rafal Edward, 52428 Jülich (DE); TAVABI, Amir Hossein, 52428 Jülich (DE)
(74) Vertreter: Gille Hrabal Partnerschaftsgesellschaft mbB Patentanwälte

(57) **Zusammenfassung**

Die Erfindung betrifft einen Probenhalter für ein Transmissionselektronenmikroskop, ein System mit einem Probenhalter und Verfahren zur Verwendung eines Probenhalters. Ein Probenhalter (10) für ein Elektronenmikroskop umfasst einen Strömungskanal (12), eine erste Wandung (21), die einen Bereich (14) des Strömungskanals (12) begrenzt, sowie einen Aktuator (15), der dazu eingerichtet ist, die erste Wandung (21) zu bewegen, um einen Querschnitt in dem Bereich (14) des Strömungskanals (12) zu beeinflussen.

## Beschreibung

Die Erfindung betrifft einen Probenhalter für ein Elektronenmikroskop, ein System mit einem Probenhalter und Verfahren zur Verwendung eines Probenhalters.

Ein Elektronenmikroskop ist ein Mikroskop, das ein Objekt mit Elektronen abbilden kann. Hierzu wird ein Strahl beschleunigter Elektronen verwendet. Bei einem Transmissionselektronenmikroskop (TEM), werden dünne Materialproben von einem fokussierten Elektronenstrahl mit hoher Energie durchdrungen. Durch die Probe gelangte Elektronen und/oder von der Probe gestreute Elektronen werden detektiert. Das resultierende Streumuster in einem oder mehreren Detektoren des Mikroskops lässt vielfältige Rückschlüsse zu, beispielsweise auf die atomare Struktur der Probe. In den Anfängen der Elektronenmikroskopie wurden die Abbildungseigenschaften der elektronenmikroskopischen Optik kontinuierlich verbessert, um Bildfehler zu korrigieren. Seit einigen Jahren liegt ein Fokus auf einer Verbreiterung der Anwendungsmöglichkeiten dieser Technik beispielsweise bei der Untersuchung von flüssigen und/oder gasförmigen Proben sowie bei der mikroskopischen Untersuchung chemischer Reaktionen.

Ein Elektronenmikroskop enthält einen Probenhalter zur Aufnahme einer Probe. Der Probenhalter sollte es ermöglichen, die Probe in einer definierten Position in Bezug zur Elektronenquelle und/oder einem Detektor zu halten. Es sind Probenhalter bekannt, die die statische Untersuchung flüssiger Proben ermöglichen. Hierbei ist allerdings die Aufnahme der Flüssigkeit in den dafür vorgesehenen Probenraum manuell durchzuführen, fehleranfällig, kompliziert und nicht reproduzierbar. Zudem sind mikrofluidische Probenhalter bekannt, die Strömungskanäle enthalten, um einen Durchfluss eines Mediums zu ermöglichen. Damit können beispielsweise mikroskopische Untersuchungen von Flüssigkeiten oder Gasen durchgeführt werden. Hierbei wird die Flüssigkeit von außen an den Probenhalter geführt, um den Probenhalter zu durchströmen.

Die oben genannten Merkmale und Eigenschaften können beliebig mit den Ausführungsformen der Erfindung kombiniert werden.

Die Aufgabe der Erfindung besteht darin, einen weiterentwickelten Probenhalter, ein zugehöriges System sowie ein Verfahren bereitzustellen.

Die Aufgabe wird gelöst durch den Probenhalter gemäß Anspruch 1 sowie durch das System und das Verfahren gemäß den nebengeordneten Ansprüchen. Vorteilhafte Ausgestaltungen sind in den Unteransprüchen angegeben.

Zur Lösung der Aufgabe dient ein Probenhalter für ein Elektronenmikroskop, umfassend einen Strömungskanal, eine erste Wandung, die einen Bereich des Strömungskanals begrenzt, sowie insbesondere einen Aktuator. Der Aktuator kann dazu eingerichtet sein, die erste Wandung zu bewegen, um einen Querschnitt in dem Bereich des Strömungskanals zu beeinflussen.

Auf diese Weise ist es möglich, den Querschnitt anzupassen, um beispielsweise für ein bestimmtes Medium einen geeigneten Querschnitt bereitzustellen. Medien mit höherer Viskosität benötigen beispielsweise größere Fließquerschnitte. Ein Austausch des Probenhalters gegen einen Probenhalter mit einem anderen Querschnitt, etwa bei Verwendung einer viskoseren Flüssigkeit, ist nicht mehr erforderlich. Es kann ein definierter Volumenstrom eines Mediums eingestellt werden. Es kann ein besonders kleiner oder dünner Querschnitt eingestellt werden, um maximale Elektronentransparenz zu ermöglichen, insbesondere in Abhängigkeit vom Medium. Fertigungstoleranzen sind weniger kritisch, weil der Querschnitt nachträglich feinjustiert werden kann. Zudem kann der Querschnitt auch während der Mikroskopie beeinflusst werden. Auf diese Weise können bisher nicht mögliche Untersuchungen an strömenden Medien durchgeführt werden. Außerdem können Gasblasen oder Verstopfungen beispielsweise durch temporäre Vergrößerung des Querschnitts gelöst oder entfernt werden. So kann der Anwendungsbereich der Elektronenmikroskopie erweitert werden.

Der Probenhalter ist geeignet zur Verwendung mit einem Elektronenmikroskop, insbesondere einem Transmissionselektronenmikroskop.

Der Strömungskanal dient zur Durchströmung mit einem Medium und/oder zur Anordnung einer zusätzlichen Probe. Es kann eine Probe, insbesondere umfassend einen Feststoff, beispielsweise Nanopartikel, im Strömungskanal angeordnet und ggf. immobilisiert werden. So kann beispielweise ein Verhalten der Probe bei Kontakt mit einem Medium untersucht werden. Es kann alternativ das Medium selbst, also typischerweise eine Flüssigkeit und/oder ein Gas, als Probe untersucht werden. Untersuchen umfasst insbesondere Bestrahlen mit Elektronen und Detektieren von Elektronen. Eine Flüssigkeit im Sinne der Erfindung ist ein im Wesentlichen flüssiger Stoff oder ein im Wesentlichen flüssiges Stoffgemisch. Auch eine Dispersion mit einem flüssigen Dispersionsmedium, beispielsweise eine Emulsion, eine Suspension oder ein Schaum, ist eine Flüssigkeit im Sinne der Erfindung. Analoges gilt für ein Gas. Auch ein Gasgemisch, ein Plasma oder ein Aerosol wie z. B. ein Rauch oder ein Nebel ist ein Gas im Sinne der Erfindung.

Der Strömungskanal ist insbesondere ein durchgehender Kanal durch den Probenhalter. Typischerweise umfasst der Probenhalter Schnittstellen, an denen ein Medium von außen, beispielsweise von einer Halteeinrichtung, in den Strömungskanal des Probenhalters hinein und/oder aus dem Strömungskanal des Probenhalters hinaus geführt werden kann. Der Strömungskanal ist bevorzugt durchgängig von einer Schnittstelle zu einer anderen Schnittstelle. Der Strömungskanal kann ein einziger, beispielsweise gebogener Hohlraum sein. Alternativ kann der Strömungskanal mehrere Hohlräume umfassen, die verbunden und/oder verzweigt sind. Es können eine oder mehrere, beispielsweise lokale Barrieren vorhanden sein, um einen Durchfluss zu zumindest lokal zu begrenzen. Ein solcher Strömungskanal kann auf einfache Weise mit bekannten Mittel gereinigt werden, beispielsweise unter Verwendung eines Ultraschallbads und/oder mit einem geeignetem Lösungsmittel.

Der Querschnitt ist ein Fließquerschnitt für das Medium. Es kann die Größe des Querschnitts, also die Fläche des Fließquerschnitts, und/oder die Form des Querschnitts beeinflusst werden. Bevorzugt werden sowohl Größe und Form des Querschnitts gleichzeitig beeinflusst. Der Querschnitt ist insbesondere ein Querschnitt des Strömungskanals.

Das Beeinflussen kann ein Einstellen umfassen. Es kann eine gewünschte Größe und/oder Form des Querschnitts eingestellt werden. Das Beeinflussen kann ein Verändern umfassen. Es kann die Größe und/oder Form des Querschnitts verändert werden. Das Verändern kann unmittelbar, also innerhalb kurzer Zeit, und/oder über eine längere Zeitdauer in einem definierten zeitlichen Verlauf erfolgen. Beispielsweise kann kontinuierlich oder schrittweise eine Veränderung von einem ersten Querschnitt zu einem davon abweichenden zweiten Querschnitt erfolgen.

Die erste Wandung begrenzt den Strömungskanal. Dies ist allerdings typischerweise nicht über die gesamte Erstreckung des Strömungskanals der Fall, sondern nur in einem Bereich des Strömungskanals, beispielsweise in einem definierten Längenbereich. Es hat sich gezeigt, dass so auf besonders einfache Weise der Querschnitt beeinflusst werden kann.

Ordnungszahlen wie "erste" Wandung, "zweite" Membran etc. dienen lediglich der begrifflichen Unterscheidung von Merkmalen. Ist eine erste Wandung vorhanden, muss nicht notwendigerweise eine zweite Wandung vorhanden sein. Ist eine zweite Membran vorhanden, muss nicht notwendigerweise eine erste Membran vorhanden sein.

Der Aktuator ist eine Baueinheit, die dazu eingerichtet ist, ein Signal in eine mechanische Bewegung, Kraft und/oder Druck umzusetzen. Der Aktuator ist insbesondere dazu eingerichtet, durch Aktivierung mittels eines oder mehrerer elektrischer Signale den Querschnitt selektiv zu beeinflussen. Es können mehrere Aktuatoren vorhanden sein, die einzeln oder gemeinsam gesteuert werden können. Der Aktuator kann die Wandung direkt oder indirekt bewegen. Bei einer indirekten Bewegung kann der Aktuator beispielsweise ein weiteres Bauteil bewegen, welches wiederum die Wandung bewegt. Die Bewegung der Wandung ist insbesondere eine Bewegung relativ zu einer anderen, zweiten Wandung bzw. zu einem anderen Teil der Wandung. Auf diese Weise kann der Querschnitt besonders zweckmäßig beeinflusst werden.

Insbesondere ist der Aktuator dazu eingerichtet, eine Längenänderung von wenigstens 0,5 nm, typischerweise wenigstens 1 nm, insbesondere wenigstens 10 nm, bevorzugt wenigstens 30 nm, insbesondere wenigstens 50 nm und/oder höchstens 1000 nm, typischerweise höchstens 300 nm, bevorzugt höchstens 200 nm, insbesondere höchstens 100 nm auszuführen. Insbesondere ist der Probenhalter so beschaffen, dass die Dicke des Querschnitts des Strömungskanals in dem Bereich auf höchstens 500 nm, insbesondere höchstens 300 nm, bevorzugt höchstens 100 nm oder 80 nm und/oder mindestens 0 nm eingestellt werden kann.

In einer Ausgestaltung ist die erste Wandung als erste Membran ausgestaltet. Eine Membran ist ein sehr dünnes flächiges Gebilde aus einem Feststoff. Eine Membran im Sinne der Erfindung weist eine Dicke auf, die um einen Faktor von mindestens 10 kleiner ist als eine Breite und eine Länge. Die Dicke der Membran ist insbesondere kleiner als 1 µm. Bevorzugt weist die Membran eine Dicke von höchstens 100 nm auf. Nach unten ist die Dicke der Membran durch die verfügbaren Materialien begrenzt. Beispielsweise können 1-atomige Membranen aus Materialien wie Graphen oder Membranen aus 2D-Materialien verwendet werden.

In einer Ausführungsform weist der Probenhalter ferner eine zweite Membran auf, die an der der ersten Membran abgewandten Seite des Strömungskanals angeordnet ist. Der Bereich des Strömungskanals wird demnach von den beiden Membranen begrenzt. Auf diese Weise kann das im Durchstrahlungsbereich befindliche Material minimiert werden.

Der Probenhalter kann ein Dichtelement zur Abdichtung des Bereichs des Strömungskanals nach außen hin aufweisen. Im Elektronenmikroskop herrscht typischerweise ein Vakuum. Wenn ein Bereich des Strömungskanals von einer Membran begrenzt wird, bevorzugt von zwei Membranen, ist es zweckmäßig, diesen Bereich gegenüber dem Vakuum abzudichten. Insbesondere wenn der Bereich zwischen zwei weiter unten beschriebenen Komponenten des Probenhalters angeordnet ist, kann so auf einfache Weise ein hinsichtlich seines Querschnitts beeinflussbarer Bereich geschaffen werden. Das Dichtelement kann beispielsweise ein O-Ring oder eine Dichtlippe sein, die z. B. auf die Oberfläche vulkanisiert sein kann. Insbesondere ist das Dichtelement um den Bereich des Strömungskanals, um den Durchstrahlungsbereich und/oder um die Membran herum angeordnet, insbesondere konzentrisch. Bevorzugt ist das Dichtelement an der zweiten Komponente befestigt und/oder im Wesentlichen in einer Aussparung der zweiten Komponenten angeordnet.

In einer Ausgestaltung umfasst der Probenhalter ferner mindestens eine mit dem Strömungskanal strömungstechnisch verbunden Eingangsschnittstelle und/oder eine mit dem Strömungskanal strömungstechnisch verbundene Ausgangsschnittstelle. Die Eingangs- bzw. Ausgangsschnittstelle dient dazu, das Medium von außerhalb in den Probenhalter strömen zu lassen. Die Schnittstellen befinden sich bevorzugt an einem Haltebereich des Probenhalters, der zum Halten durch eine Halteeinrichtung eingerichtet ist. Die Halteeinrichtung hat an entsprechenden Stellen bevorzugt korrespondierende Schnittstellen, sodass das Medium entsprechend übergeben werden kann.

In einer Ausgestaltung umfasst der Aktuator ein piezoelektrisches Material. Das piezoelektrische Material ist so eingerichtet, dass es die Membran direkt oder indirekt bewegen kann, um den Querschnitt zu beeinflussen. Insbesondere sind zwei Anschlüsse zur elektrischen Kontaktierung des piezoelektrischen Materials vorhanden. Insbesondere umfasst der Probenhalter zwei elektrischen Kontakte, an denen eine elektrische Spannung zur Betätigung des Aktuators zum Probenhalter geführt werden können. Das piezoelektrische Material ist so beschaffen, dass es sich aufgrund des inversen Piezoeffekts bei Anliegen einer elektrischen Spannung verformt. Insbesondere verändert das piezoelektrische Material seine Länge in zumindest einer Ausdehnungsrichtung. Solange die Spannung anliegt, bleibt die Verformung bestehen. Die Verformung ist allerdings reversibel. Bei Wegfall der elektrischen Spannung nimmt das piezoelektrische Material wieder seine ursprüngliche Form an. Auf diese Weise kann der Querschnitt in dem betreffenden Bereich des Strömungskanals besonders einfach und exakt beeinflusst werden. Es hat sich gezeigt, dass durch ein piezoelektrisches Material der Querschnitt des Strömungskanals besonders exakt eingestellt werden kann.

Insbesondere wird eine piezoelektrische Keramik verwendet. Diese Materialien ermöglichen eine besonders starke Längenänderung und sind zudem gut verfügbar.

In einer Ausgestaltung ist der Aktuator zwischen zwei Komponenten des Probenhalters angeordnet. in einer Ausgestaltung ist der Aktuator eingerichtet, einen Abstand zwischen zwei Komponenten des Probenhalters selektiv zu beeinflussen.

Eine Komponente ist ein Bauteil des Probenhalters. Insbesondere ist zumindest eine der zwei Komponenten zumindest geringfügig flexibel. Eine elastische Verformung um weniger als 1 µm ist dafür typischerweise ausreichend. Der Aktuator kann unmittelbar an eine oder beide Komponenten angrenzen. Es können auch eine oder mehrere Zwischenschichten zwischen dem Aktuator und einer jeweiligen Komponente vorhanden sein. Bei der Änderung des Abstands kann eine oder zwei der Komponenten insbesondere elastisch verformt werden. Die Änderung des Abstands kann reversibel sein. Insbesondere durch elastische Eigenschaften der benachbarten Komponenten kann die Verformung bei Wegfall der die Verformung auslösenden Kraft und/oder Bewegung des Aktuators ebenfalls wegfallen.

Eine erste Komponente kann ein Chip sein, der die erste oder zweite Wandung trägt, etwa in Form einer Membran. Der Chip kann Silizium, Siliziumnitrid und/oder andere vakuumzugelassene und elektronenstrahlresistente Materialien umfassen oder daraus hergestellt sein. Im idealen Fall ist die Membran transparent für den Elektronenstrahl. Eine zweite Komponente kann ein Cover sein, also eine Abdeckung, die die erste Komponente zumindest bereichsweise abdeckt. Die zweite Komponente kann Silizium, Siliziumnitrid, Glas, Titan Kunststoff und/oder andere vakuumzugelassene und elektronenstrahlresistente Materialien umfassen oder daraus hergestellt sein. Die beiden Komponenten können gegeneinander gepresst werden. Eine oder beide Komponenten können aus Glas, Metall und/oder Kunststoff hergestellt sein. Insbesondere sind die Komponenten vakuumkompatibel. Der Strömungskanal kann sich im Wesentlichen, insbesondere in den außerhalb des Bereichs liegenden Abschnitten, in einer der Komponenten erstrecken, z. B. im Cover. Die andere Komponente kann dann besonders einfach hergestellt werden. Ein Herstellen eines Strömungskanals im Inneren dieser Komponente ist dann nicht erforderlich. Die den Strömungskanal aufweisende Komponente kann wechselbar, insbesondere als Wegwerfartikel ausgestaltet sein. So kann im Falle einer nicht vollständig möglichen Reinigung und/oder zur Verwendung einer Komponente mit anderen Eigenschaften wie z. B. einem anderen Fließquerschnitt, ein Austausch ermöglicht werden.

Im Fall einer transparenten Komponente kann ein Strömungskanal z. B. durch "selective laser etching" (selektives Laserätzen, SLE) hergestellt sein. Dieses Verfahren erlaubt die Herstellung feiner dreidimensionaler Strukturen aus transparenten Werkstoffen wie z. B. Glas oder Saphir, wobei letzteres zudem eine gute Wärmeleitung im Niedertemperaturbereich (Kryotechnik). Hohlräume wie Strömungskanäle im Inneren eines Körpers können auf diese Weise besonders vorteilhaft hergestellt werden.

Insbesondere umfasst die erste Komponente und/oder die zweite Komponente eine Aussparung, in welcher der Aktuator angeordnet ist. Eine Komponente kann auch eine im Wesentlichen oder vollständig ebene Kontaktfläche zur direkten oder indirekten Kontaktierung des Aktuators aufweisen.

In einer Ausgestaltung weist der Probenhalter einen Durchstrahlungsbereich auf, der insbesondere zum Durchstrahlen mittels eines Elektronenstrahls eingerichtet ist. Insbesondere hat das im Durchstrahlungsbereich vorhandene Material des Probenhalters eine Gesamtdicke von weniger als 5 µm, bevorzugt weniger als 1 µm, besonders bevorzugt weniger als 200 nm, typischerweise weniger als 100 nm und in einigen Ausführungsformen höchstens 60 nm. Die Untergrenze der Gesamtdicke des Materials kann je Membran durch eine einatomige Schicht definiert sein. Die Gesamtdicke kann größer als 1 nm, insbesondere als 10 nm sein. Der Elektronenstrahl muss demnach zusätzlich zur Probe nur wenig Material des Probenhalters durchdringen.

Der Durchstrahlungsbereich ist ein weitestgehend freier Pfad, bei dem in der Transmissionselektronenmikroskopie Elektronen durch eine Probe geleitet werden können. Insbesondere durchströmen die Elektronen die Membran, die als dünne Schicht den Bereich des Strömungskanals begrenzt. Insbesondere ist an der jeweiligen dem Strömungskanal abweichenden Seite einer oder mehrerer Membranen kein Material vorhanden. Insbesondere sind entsprechende Aussparungen vorhanden, beispielsweise in entsprechenden ersten und/oder zweiten Komponenten des Probenhalters, die den bevorzugt geradlinigen Durchstrahlungsbereich definieren. Wände der Aussparungen können winklig und/oder konisch verlaufen, um in unterschiedliche Winkeln ausgesendete und/oder abgestrahlte Elektronen erfassen zu können und/oder um die Probe unter unterschiedlichen Winkeln untersuchen zu können. Hierzu kann beispielsweise eine geeignete Drehung des Probenhalters erfolgen. Insbesondere verläuft der Durchstrahlungsbereich durch den gesamten Probenhalter. Insbesondere verläuft der Durchstrahlungsbereich senkrecht zu den Hauptflächen des Probenhalters.

In einer Ausgestaltung weist der Probenhalter ferner eine zweite Wandung auf, insbesondere eine zweite Membran, die an der der ersten Wandung abgewandten Seite des Strömungskanals angeordnet ist. Insbesondere sind die erste Wandung und die zweite Wandung parallel zueinander angeordnet oder anordbar. So kann sich ein konstanter Querschnitt des Bereichs des Strömungskanals ergeben. Alternativ können die erste Wandung und die zweite Wandung in einer nicht parallel verlaufenden Anordnung positioniert oder positionierbar sein. So kann sich ein verjüngender und/oder sich erweiternder Querschnitt des Bereichs des Strömungskanals ergeben. Die Anordnung oder Positionierung kann durch den Aktuator erreicht werden.

In einer weiteren Ausgestaltung ist zumindest ein Abschnitt des Strömungskanals spiralförmig. Der Abschnitt kann um den Bereich herum angeordnet sein und/oder den Bereich umfassen. Der Abschnitt kann einen sich verjüngenden und/oder sich erweiternden Querschnitt aufweisen. Diese Ausgestaltung ermöglicht die Einstellung bestimmter Strömungsbedingungen im Probenhalter. Ein Medium kann so zur Mitte der Spirale strömen.. Eine besonders geformte Spirale ist dabei nicht erforderlich. Insbesondere verläuft der spiralförmige Abschnitt des Strömungskanals mindestens einmal vollständig, also um 360°, um den Bereich herum. In einer Ausführungsform verläuft die Spirale in einer Ebene.

In einer Ausgestaltung verläuft der Bereich des Strömungskanals und/oder der Durchstrahlungsbereich durch einen Punkt im Inneren des spiralförmigen Abschnitts. Insbesondere verläuft der Durchstrahlungsbereich bzw. der Bereich des Strömungskanals in Blickrichtung entlang der Richtung des Elektronenstrahls im Inneren der Spirale. Insbesondere befindet sich der Durchstrahlungsbereich bzw. der Bereich des Strömungskanals auf der Mittelachse der Spirale. Es können dann besonders klar definierte Strömungsbedingungen eingestellt werden.

Die spiralförmige Ausgestaltung eines Abschnitts des Strömungskanals ist auch eine eigenständige Lehre zur Lösung der Aufgabe. Ein Aspekt der Erfindung ist demnach ein Probenhalter für ein Elektronenmikroskop, der einen Strömungskanal umfasst, wobei zumindest ein Abschnitt des Strömungskanals spiralförmig geformt ist. Alle Merkmale, Eigenschaften und Vorteile des ferner beschriebenen Probenhalters gelten auch für diesen Aspekt und umgekehrt.

In einer Ausgestaltung weist der Probenhalter eine erste Komponente und eine zweite Komponente auf. Insbesondere ist die erste Wandung, bevorzugt die erste Membran, zwischen der ersten Komponente und der zweiten Komponente angeordnet. Insbesondere ist die erste Wandung in Blickrichtung quer zur Richtung des Elektronenstrahls zwischen den zwei Komponenten angeordnet. Zwischen den Komponenten bedeutet, dass zumindest eine Gerade vorhanden ist, auf der in dieser Reihenfolge Material der ersten Komponente, die ersten Membran und Material der zweiten Komponente angeordnet ist.

Eine oder beide Komponenten können länglich und/oder plattenförmig sein. Die Ausdehnung in der Höhe ist dann um den Faktor von wenigstens 3, insbesondere wenigstens 5 kleiner als die Ausdehnung in der Länge und/oder Breite. Insbesondere ist auch die zweite Wandung, insbesondere die zweite Membran, zwischen der ersten Komponente und der zweiten Komponente angeordnet.

In einer Ausführungsform sind die erste Komponente und die zweite Komponente mittels mindestens eines Befestigungsmittels miteinander verbunden. Das Befestigungsmittel dient insbesondere der direkten mechanischen Verbindung der zwei Komponenten derart, dass ein Trennen der zwei Komponenten kraft- und/oder formschlüssig verhindert wird. Direkt meint, dass ein Trennen nicht durch andere, außenliegende Bauteile verhindert wird. Beispielsweise können die beiden Komponenten miteinander verschraubt sein. Es kann selbstverständlich möglich sein, dass eine oder mehrere Zwischenschichten zumindest bereichsweise zwischen den Komponenten angeordnet sind. Alternativ können die zwei Komponenten an einem dritten Teil gehalten sein. Als Befestigungsmittel kann mindestens eine Schraube dienen. Alternativ oder ergänzend kann mindestens eine Feder verwendet werden. Dabei können die Komponenten mit einer Feder oder einem Federmechanismus miteinander verklemmt sein.

In einer Ausgestaltung ist der Bereich des Strömungskanals selektiv verschließbar, insbesondere mittels des Aktuators. Insbesondere ist der Aktuator so eingerichtet, dass der Strömungskanal verschlossen werden kann, beispielsweise durch Bewegung der ersten Wandung, und/oder die erste und/oder zweite Komponente ist so eingerichtet, dass der Strömungskanal verschlossen werden kann. Der Querschnitt des Strömungskanals kann so einerseits in einem besonders großen Bereich variiert werden. Darüber hinaus wird so eine Vielzahl neuartiger Anwendungen ermöglicht. Beispielsweise kann der Bereich des Strömungskanals als Ventil oder Pumpe dienen.

Ein weiterer Aspekt der Erfindung ist ein System, das einen insbesondere erfindungsgemäßen Probenhalter und ein Steuerungsgerät umfasst. Das Steuerungsgerät dient insbesondere der elektrischen Steuerung des Aktuators, sodass das Steuerungsgerät den Aktuator zu steuern vermag, um den Querschnitt im Bereich des Strömungskanals zu beeinflussen. Das Steuerungsgerät ist insbesondere räumlich getrennt von dem Probenhalter und insbesondere ebenfalls von der Lanze, sodass eine Steuerung aus der Ferne möglich ist, ohne in das Elektronenmikroskop eingreifen zu müssen. Alle Merkmale, Eigenschaften und Vorteile des eingangs beschriebenen Probenhalters gelten insbesondere ebenso für das System und umgekehrt.

Ein weiterer Aspekt der Erfindung ist ein Steuerungsgerät für einen insbesondere erfindungsgemäßen Probenhalter. Alle Merkmale, Eigenschaften und Vorteile des eingangs beschriebenen Probenhalters sowie des Systems gelten insbesondere ebenso für das Steuerungsgerät und umgekehrt.

Ein weiterer Aspekt der Erfindung ist ein Verfahren zur Verwendung eines Probenhalters, der einen Strömungskanal, eine erste Wandung, die einen Bereich des Strömungskanals begrenzt, sowie einen Aktuator umfasst, insbesondere eines erfindungsgemäßen Probenhalters. Das Verfahren umfasst Bewegen der ersten Wandung mittels des Aktuators, insbesondere relativ zu einer zweiten Wandung, um einen Querschnitt in dem Bereich des Strömungskanals zu beeinflussen.

In einer Ausgestaltung wird der Querschnitt beeinflusst, während eine im Probenhalter befindliche Probe mit einem Elektronenstrahl beschossen wird und/oder während ein Medium durch den Bereich des Strömungskanals strömt. Der Querschnitt kann während der Elektronenstrahlmikroskopie beeinflusst werden, beispielsweise geändert werden.

In einer Ausgestaltung wird durch wiederholte Verjüngung und Vergrößerung des Querschnitts eine Schwingung erzeugt. Insbesondere erfolgt eine Schwingung bei einer definierten, beispielsweise gleichbleibenden Frequenz. Dazu kann der Aktuator in der gewünschten Frequenz angeregt werden, beispielsweise mittels eines Steuerungsgeräts, beispielsweise unter Verwendung eines Wellensignals. Es kann eine aktive fluidmechanische Manipulation der Probe und/oder eines Mediums erfolgen. Es kann zum Beispiel eine Ultraschallanregung einer Probe und/oder eines Mediums erfolgen. Es können Vibrationen erzeugt werden. Es kann beispielsweise eine Emulsion hergestellt werden und/oder eine Viskosität beeinflusst werden. Hierfür können insbesondere hochfrequente Oszillationen verwendet werden. Es kann durch wiederholtes, zumindest teilweises Öffnen und Schließen des Querschnitts in dem Bereich ein pulsierender Durchfluss erzeugt werden und/oder ein Pumpeffekt erzielt werden. Hierfür können beispielsweise vergleichsweise niederfrequentere Oszillationen verwendet werden. Grundsätzlich können Frequenzen von wenigen Hertz oder darunter bis zu mehreren Hundert MHz erzeugt werden. Bei kleinem Aktuator und/oder bei der Erzeugung lediglich oberflächennaher akustischer Wellen und/oder von Wellen mit nur geringen Amplituden können Frequenzen von mehr als 10 GHz erzeugt werden. Insbesondere ist das Steuerungsgerät dazu eingerichtet, einen oder mehrere der beschriebenen Effekte zu ermöglichen.

Nachfolgend werden Ausführungsbeispiele der Erfindung auch anhand von Figuren näher erläutert. Merkmale der Ausführungsbeispiele können einzeln oder in einer Mehrzahl mit den beanspruchten Gegenständen kombiniert werden, sofern nichts Gegenteiliges angegeben ist. Die beanspruchten Schutzbereiche sind nicht auf die Ausführungsbeispiele beschränkt.

Es zeigen:
- Figur 1:: eine perspektivische Darstellung einer Lanze mit Probenhalter,
- Figur 2:: eine vergrößerte Darstellung eines Probenhalters,
- Figur 3:: eine Querschnittszeichnung eines Probenhalters,
- Figuren 4 und 5:: geschnittene Darstellungen eines Probenhalters
- Figuren 6 und 7:: perspektivische Darstellung eines Teils eines Probenhalters, sowie
- Figur 8:: eine schematische Darstellung eines Systems.

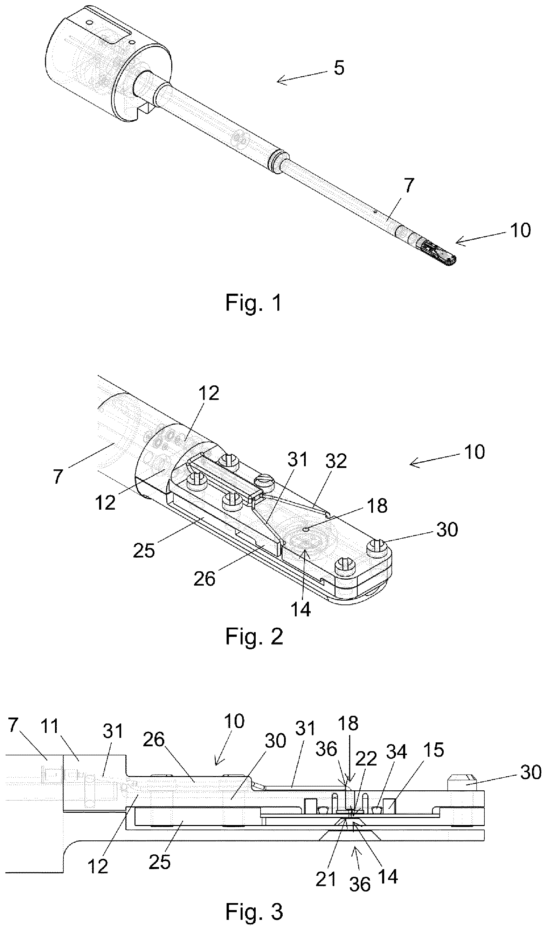

Figur 1 zeigt eine Lanze 5 mit einem Probenhalter 10 für ein Elektronenmikroskop, insbesondere für die Transmissionselektronenmikroskopie. Die Lanze umfasst eine Halteeinrichtung 7, an welche der Probenhalter 10 gekoppelt werden kann. Es ist anzumerken, dass in anderen Zusammenhängen auch die Einheit aus Lanze 5 und Probenhalter 10 als "Probenhalter" bezeichnet wird. Der Probenhalter 10 kann demnach die Lanze 5 umfassen. Die Halteeinrichtung 7 hält den Probenhalter 10 bzw. die zwei Komponenten des Probenhalters 10 und ist insbesondere dazu eingerichtet, ein Medium zum Probenhalter 10 hin und vom Probenhalter 10 weg zu führen und/oder den Probenhalter 10 mit Elektrizität zu versorgen. Der Probenhalter 10 kann die Halteeinrichtung 7 umfassen. In diesem Fall kann an einer in den Zeichnungen nicht dargestellten Position der Halteeinrichtung 7 eine Schnittstelle zur Übergabe von Medium und/oder Elektrizität zu dem Probenhalter vorhanden sein. Die Halteeinrichtung kann als TEM-Halter bezeichnet werden. Die gezeigten Figuren lehnen sich rein beispielhaft an Probenhalter für TFS-Probenhaltern an. Es ist selbstverständlich ebenso möglich, die Erfindung für andere Geräte wie z. B. JEOL-Geräte auszugestalten.

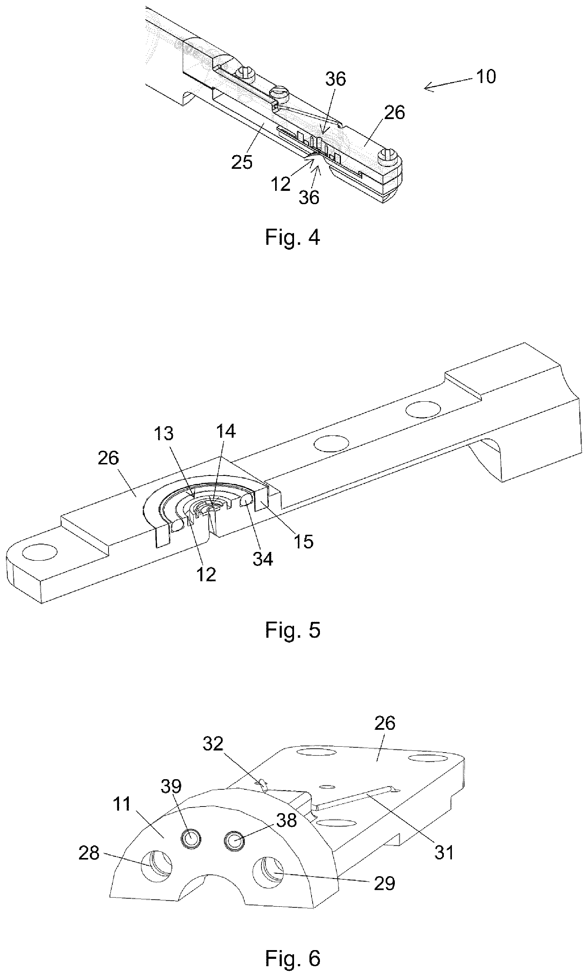

Die Figuren 2 und 3 zeigen jeweils einen Probenhalter 10, beispielsweise den Probenhalter 10 aus Figur 1, in einer vergrößerten, halb transparenten Darstellung. Der Probenhalter 10 umfasst einen Haltebereich 11, welcher an die Halteeinrichtung 7 gekoppelt ist. Der Haltebereich 11 umfasst mehrere Schnittstellen, um ein Medium und Elektrizität von der Halteeinrichtung zum Probenhalter 10 zu führen, wie unten im Bezug zu Figur 6 im Detail beschrieben wird.

Der Probenhalter 10 umfasst eine untere erste Komponente 25 und eine obere zweite Komponente 26. Die erste Komponente 25 und/oder die zweite Komponente 26 sind beispielsweise aus Glas hergestellt. Die erste Komponente 25 und die zweite Komponente 26 sind mittels Befestigungsmitteln, die hier beispielhaft als Schrauben 30 ausgestaltet sind, miteinander verbunden. Rein beispielhaft ist in der hier gezeigten Ausführungsform zudem eine untere Platte der Halteeinrichtung 7 vorhanden, die sich unterhalb der ersten Komponente 25 erstreckt. Die Platte kann die erste Komponente 25 und/oder die zweite Komponente 26 halten, ist jedoch zur Lösung der Aufgabe nicht erforderlich.

Der Probenhalter 10 umfasst einen in der zweiten Komponente 26 angeordneten Strömungskanal 12, der hier beispielhaft von einer Eingangsschnittstelle am Haltebereich 11 bis zu einem im Durchstrahlungsbereich 18 befindlichen Bereich 14 im vorderen Abschnitt des Probenhalters 10 und wieder zurück zu einer Ausgangsschnittstelle am Haltebereich 11 verläuft. In anderen Ausführungsformen sind abweichende und/oder ergänzende Strömungskanäle möglich. Beispielsweise kann ein zusätzlicher Strömungskanal von einer zusätzlichen Eingangsschnittstelle am Haltebereich 11 zu einem Kreuzungspunkt verlaufen. Der Kreuzungspunkt kann sich beispielsweise stromaufwärts des Durchstrahlungsbereichs 18 befinden.

Der Durchstrahlungsbereich 18 dient der Durchstrahlung einer zu untersuchenden Probe und/oder eines zu untersuchenden Mediums mit Elektronen. Der Durchstrahlungsbereich 18 ist dadurch gekennzeichnet, dass in einem geradlinigen Strahlungspfad die zu durchstrahlende Probe und/oder das zurück strahlende Medium mit möglichst wenig Material gehalten wird. Dadurch ist möglichst wenig Material vorhanden, welches von den Elektronen durchstrahlt werden muss. Um dies zu erreichen sind einerseits sowohl in der ersten Komponente 25 als auch in der zweiten Komponente 26 jeweilige Aussparungen 36 vorhanden. Wie insbesondere in Figur 3 ersichtlich ist, ist in der oberen zweiten Komponente 26 eine Aussparung 36 mit einer im Wesentlichen zylindrischen Form vorhanden und in der unteren ersten Komponente 25 ist eine pyramidenförmige oder konische Aussparung 36 vorhanden. Die Elektronen können so senkrecht zu den Oberflächen der ersten Komponente 25 sowie der zweiten Komponente 26 den Probenhalter 10 durchdringen. Aussparungen können beispielsweise durch selektives Ätzen hergestellt werden.

Der im Durchstrahlungsbereich 18 befindliche Bereich 14 des Strömungskanals 12 ist von zwei Wandungen 21, 22 begrenzt. Beispielhaft ist jede der zwei Wandungen 21, 22 als eine Membran ausgestaltet. So wird die Menge des von den Elektronen zu durchstrahlenden Materials minimiert. Eine erste Membran 21 ist an der Oberseite der ersten Komponente 25 befestigt. Insbesondere überspannt die erste Membran 21 eine Durchgangsöffnung des die Aussparung 36 ausbildenden Materials der ersten Komponente 25. Eine zweite Membran 22 ist an der Unterseite der zweiten Komponente 26 befestigt. Insbesondere überspannt die zweite Membran 22 eine Durchgangsöffnung des die Aussparung 36 ausbildenden Materials der zweiten Komponente 26. Auf diese Weise müssen die Elektronen lediglich die zwei Membranen 21, 22 sowie das im dazwischen liegenden Bereich 14 des Strömungskanals 12 befindliche Medium und/oder die dort befindliche Probe durchströmen.

In der Nähe des Bereichs 14 des Strömungskanals 12, hier beispielhaft um den Bereich 14 herum angeordnet, befindet sich ein Aktuator 15. Der Aktuator 15 ist dazu eingerichtet, bei Bedarf gezielt die erste Wandung 21 zu bewegen, um den Querschnitt des Strömungskanals 12 in dem Bereich 14 zu beeinflussen. Im hier gezeigten Ausführungsbeispiel ist der Aktuator 15 derart zwischen der ersten Komponente 25 und der zweiten Komponente 26 angeordnet, dass er die zwei Komponenten 25, 26 bereichsweise auseinander drücken kann und damit auch den Abstand zwischen den daran angeordneten Membranen beeinflusst. Der Aktuator 15 umfasst ein piezoelektrisches Material, welches mittels eines ersten Leiters 31 und eines zweiten Leiters 32 mit einer elektrischen Spannung beaufschlagt werden kann. Liegt eine elektrische Spannung an, verändert sich die Dicke des piezoelektrischen Materials.

Vergrößert sich die Dicke des piezoelektrischen Materials, werden die erste Komponente 25 und die zweite Komponente 26 auseinandergedrückt. Somit vergrößert sich auch der Abstand zwischen der ersten Wandung 21 und der zweiten Wandung 22 und der Querschnitt in dem Bereich 14 des Strömungskanals 12 vergrößert sich. Im umgekehrten Fall, wenn sich die Dicke des piezoelektrischen Materials verringert, verringert sich der Abstand zwischen der ersten Komponente 25 und der zweiten Komponente 26. Somit verringert sich auch der Abstand zwischen den zwei Wandungen 21, 22 und der Querschnitt in dem Bereich 14 des Strömungskanals 12 wird kleiner. Das piezoelektrische Material hat insbesondere eine entlang der Richtung des Elektronenstrahls gemessene Dicke von mehr als 0,1 mm, bevorzugt mehr als 0,5 mm und/oder weniger als 2 mm, bevorzugt weniger als 1 mm.

Wie in den Figuren 2 und 3 erkennbar ist, ist der Aktuator 15 oder das piezoelektrische Material im hier gezeigten Beispiel ringförmig ausgestaltet und verläuft um den Bereich 14 herum. Die Mittelachse der Ringform verläuft entlang der Richtung des Elektronenstrahls. Der Elektronenstrahl verläuft in Figur 3 in vertikaler Richtung parallel zu den Oberflächen des Probenhalters 10 durch die Aussparungen 36 und den Bereich 14 hindurch.

Der Probenhalter umfasst ein Dichtelement 34 in Form eines O-Rings, mit dem der Bereich 14 nach außen abgedichtet wird. Der O-Ring 34 befindet sich zwischen der ersten Komponente 25 bzw. der ersten Membran und der zweiten Komponente 26 bzw. der zweiten Membran. Insbesondere wird der O-Ring 34 mittels der Befestigungsmittel bzw. Schrauben 30 an die genannten Komponenten bzw. Membranen gepresst. So wird ein Ausströmen des Mediums aus dem Strömungskanal 12 in das in der Umgebung des Probenhalters 10 üblicherweise befindliche Vakuum verhindert. Im hier gezeigten Beispiel befindet sich der O-Ring 34 radial innerhalb des Aktuators 15 und/oder konzentrisch zum Aktuator 15. So wird eine kurze Abdichtung bereitgestellt, die eine geringe Fehleranfälligkeit aufweist. Grundsätzlich kann auch eine anderes, beispielsweise spezifisch angepasstes Dichtelement vorgesehen sein, welches ggf. direkt mit dem Glaskörper verbunden sein kann. Das Dichtelement kann grundsätzlich einen beliebigen Querschnitt aufweisen.

Die Figuren 4 und 5 zeigen den Probenhalter in einer geschnittenen perspektivischen Darstellung, in der die zwei Komponenten 25, 26 und die Anordnung des O-Rings, des Aktuators und der Aussparungen 36 um den Bereich herum sichtbar sind. In Figur 4 verläuft der Strömungskanal 12 in Draufsicht zumindest im Wesentlichen geradlinig entlang der Längserstreckung des Probenhalters. In Figur 5, in der für eine bessere Sichtbarkeit zudem die erste Komponente 25 weggelassen ist, weist der Strömungskanal 12 dagegen einen spiralförmigen Abschnitt 13 auf und hat zudem einen sich erweiternden oder sich verjüngenden Querschnitt. Der Bereich 14 des Strömungskanals 12, dessen Querschnitt beeinflusst werden kann, befindet sich zentral in der Spirale.

Figur 6 zeigt den Haltebereich 11 zum Koppeln des Probehalters 10 an die oben beschriebene Halteeinrichtung. Der Probenhalter 10 weist im Haltebereich 11 eine Eingangsschnittstelle und eine Ausgangsschnittstelle für das Medium auf, die mit dem Strömungskanal in Fließverbindung stehen. Zudem weist der Probenhalter 10 im Haltebereich 11 einen ersten elektrischen Kontakt 38 und einen zweiten elektrischen Kontakt 39 auf, mit dem der mindestens eine Aktuator angesteuert werden kann. Die elektrischen Kontakte 38, 39 sind dafür mit jeweils mit einem elektrischen Leiter 31, 32 verbunden, die wiederum mit dem Aktuator verbunden sind.

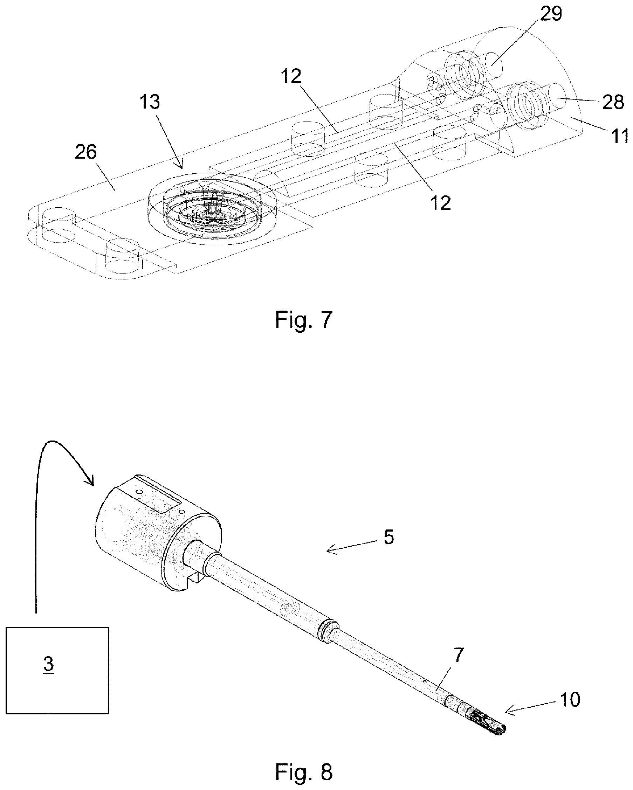

Figur 7 zeigt eine Ausgestaltung eines Probenhalters 10, bei dem der Strömungskanal 12 einen spiralförmigen Abschnitt 13 aufweist. Die halbtransparente Darstellung macht auch die innenliegenden Teile wie den Strömungskanal 12 und die Eingangs- und Ausgangsschnittstelle 28, 29 sichtbar.

Alternativ zur oben beschriebenen Ringform kann der Aktuator oder das piezoelektrische Material die Form eines Teil eines Rings aufweisen, der sich ausgehend von dem Mittelpunkt des Rings über einen bestimmten Winkelbereich zwischen 0° und < 360° erstreckt. Der Winkelbereich ist typischerweise größer als 180° oder 270°. Auf diese Weise kann gezielt eine Vergrößerung oder Verkleinerung des Querschnitts des Strömungskanals 12 in dem Bereich 14 erzielt werden. Hierbei wird der Strömungskanal im gesamten Bereich 14 typischerweise einheitlich vergrößert bzw. verkleinert. Die Wandungen 21, 22 sind im vom Druck des Mediums unbeaufschlagtem Zustand typischerweise parallel zueinander ausgerichtet.

Ist nur ein Element aus piezoelektrischem Material vorhanden, wird eine minimale Anzahl an elektrischen Leitungen benötigt. In einer weiteren Alternative kann der Aktuator 15 mehrere Elemente aus piezoelektrischem Material aufweisen, die um den Bereich 14 herum verteilt sein können, beispielsweise auf einem Kreis oder Kreisbogen. Mehrere oder alle dieser Elemente können zusammen geschaltet sein, so dass eine Längenänderung aller Elemente gleichzeitig und/oder gleichförmig erfolgt. So können beispielsweise Kippbewegungen ausgeführt werden. Sind mehrere Aktuatoren oder mehrere Elemente aus piezoelektrischem Material vorhanden, können diese auch einzeln und/oder in Gruppen derart geschaltet sein, dass eine Längenänderung nur eines oder einiger Elemente erfolgt und/oder dass unterschiedliche Längenänderungen unterschiedlicher Elemente und/oder Gruppen von Elementen erfolgt. Auf diese Weise kann der Querschnitt über den Bereich 14 unterschiedlich vergrößert bzw. verkleinert werden. Beispielsweise können die Wandungen 21, 22 im Bereich 14 durch mehrere einzeln geschaltete Elemente bzw. Aktuatoren durch gezielte Spannungsbeaufschlagung reversibel so ausgerichtet werden, dass sie eine schräge Ausrichtung, z. B. eine Keilform beschreiben. Der Querschnitt kann beispielsweise so eingestellt werden, dass er sich entlang der Fließrichtung des Mediums erweitert oder verjüngt. Es kann möglich sein, durch eine andere Spannungsbeaufschlagung eine andere, beispielsweise entgegengesetzt ausgerichtete Keilform zu erzeugen. Es kann so möglich sein, ohne Fließrichtungsumkehr des Mediums einen sich verjüngenden Querschnitt, einen konstanten Querschnitt und einen sich vergrößernden Querschnitt zu erzeugen. Für n separate gesteuerte piezoelektrische Elemente werden typischerweise mindestens n+1 elektrische Leitungen und/oder höchstens 2*n elektrische Leitungen benötigt.

Figur 8 zeigt auf schematische Weise ein System, das einen Probenhalter 10 und ein Steuerungsgerät 3 umfasst. Ein Pfeil stellt eine datentechnische Verbindung zwischen dem Steuerungsgerät 3 und dem Probenhalter 10 dar, die kabelgebunden und/oder kabellos sein kann. Bevorzugt ist das Steuerungsgerät mit der Lanze 5 kabelgebunden oder kabellos verbunden und die Lanze ist kabelgebunden mit dem Probenhalter verbunden, bevorzugt über den oben beschriebenen Haltebereich mit den mindestens zwei Leitern.

Das Steuerungsgerät 3 ist insbesondere mit mehreren Elementen des Aktuators elektrisch verbunden ist und dazu eingerichtet, die mehrere Elemente des Aktuators zusammen und/oder einzeln, ggf. in Gruppen, anzusteuern. Auf diese Weise können die beschriebenen Effekte erreicht werden.

Der Probenhalter kann zudem zwei elektrische Kontakte zur elektrischen Kontaktierung mit der Probe aufweisen. Die elektrischen Kontakte sind insbesondere in dem Bereich des Strömungskanals angeordnet. Insbesondere sind dann zwei elektrische Leitungen vorhanden, die von jeweiligen Schnittstellen am Haltebereich zu einem jeweiligen elektrischen Kontakt im Bereich verlaufen. Ein Steuerungsgerät kann dazu eingerichtet sein, eine elektrische Kontaktierung der Probe zu steuern, beispielsweise selektiv eine elektrische Spannung und/oder einen elektrischen Strom über die elektrischen Kontakte an die Probe und/oder an ein die Probe enthaltendes Medium anzulegen.

### Bezugszeichenliste

| | |
|---|---|
| Steuerungsgerät | 3 |
| Lanze | 5 |
| Halteeinrichtung | 7 |
| Probenhalter | 10 |
| Haltebereich | 11 |
| Strömungskanal | 12 |
| Abschnitt | 13 |
| Bereich | 14 |
| Aktuator | 15 |
| Durchstrahlungsbereich | 18 |
| erste Wandung | 21 |
| zweite Wandung | 22 |
| erste Komponente | 25 |
| zweite Komponente | 26 |
| Eingangsschnittstelle | 28 |
| Ausgangsschnittstelle | 29 |
| Schraube | 30 |
| Erster Leiter | 31 |
| Zweiter Leiter | 32 |
| O-Ring | 34 |
| Aussparung | 36 |
| Erster elektrischer Kontakt | 38 |
| Zweiter elektrischer Kontakt | 39 |

## Patentansprüche

1. Probenhalter (10) für ein Elektronenmikroskop, umfassend einen Strömungskanal (12), eine erste Wandung (21), die einen Bereich (14) des Strömungskanals (12) begrenzt, sowie einen Aktuator (15), der dazu eingerichtet ist, die erste Wandung (21) zu bewegen, um einen Querschnitt in dem Bereich (14) des Strömungskanals (12) zu beeinflussen.

2. Probenhalter (10) nach dem vorhergehenden Anspruch, wobei die erste Wandung (21) als erste Membran ausgestaltet ist.

3. Probenhalter (10) nach dem vorhergehenden Anspruch, ferner umfassend mindestens eine mit dem Strömungskanal (12) strömungstechnisch verbunden Eingangsschnittstelle (28) und eine mit dem Strömungskanal (12) strömungstechnisch verbundene Ausgangsschnittstelle (29).

4. Probenhalter (10) nach einem der vorhergehenden Ansprüche, wobei der Aktuator (15) ein piezoelektrisches Material umfasst.

5. Probenhalter (10) nach einem der vorhergehenden Ansprüche, wobei der Aktuator (15) zwischen zwei Komponenten (25, 26) des Probenhalters (10) angeordnet ist und dazu eingerichtet ist, einen Abstand zwischen den zwei Komponenten (25, 26) selektiv zu beeinflussen.

6. Probenhalter (10) nach einem der vorhergehenden Ansprüche, wobei der Probenhalter (10) einen Durchstrahlungsbereich (18) zum Durchstrahlen mittels eines Elektronenstrahls aufweist, wobei im Durchstrahlungsbereich (18) vorhandenes Material insbesondere eine Gesamtdicke von weniger als 5 µm hat.

7. Probenhalter (10) nach einem der vorhergehenden Ansprüche, wobei der Probenhalter (10) ferner eine zweite Wandung (22) aufweist, insbesondere eine zweite Membran, die an einer der ersten Wandung (21) abgewandten Seite des Strömungskanals (12) angeordnet ist,
insbesondere wobei die erste Wandung (21) und die zweite Wandung (22) parallel zueinander angeordnet sind und einen konstanten Querschnitt des Bereichs (14) des Strömungskanals (12) begrenzen, und/oder
wobei die erste Wandung (21) und die zweite Wandung (22) in einer nicht parallel zueinander verlaufenden Anordnung positionierbar sind und einen sich verjüngenden und/oder sich erweiternden Querschnitt des Bereichs (14) des Strömungskanals (12) begrenzen.

8. Probenhalter (10) nach einem der vorhergehenden Ansprüche, wobei zumindest ein Abschnitt (13) des Strömungskanals (12) spiralförmig ist und insbesondere einen sich verjüngenden und/oder sich erweiternden Querschnitt aufweist.

9. Probenhalter (10) nach dem vorhergehenden Anspruch, wobei der Bereich (14) des Strömungskanals (12) und/oder der Durchstrahlungsbereich (18) durch einen Punkt im Inneren des spiralförmigen Abschnitts (13) verläuft.

10. Probenhalter nach einem der vorhergehenden Ansprüche, wobei der Probenhalter eine erste Komponente (25) und eine zweite Komponente (26) aufweist, wobei die erste Wandung (21) zwischen der ersten Komponente (25) und der zweiten Komponente (26) angeordnet ist.

11. Probenhalter (10) nach einem der vorhergehenden Ansprüche, wobei der Bereich (14) des Strömungskanals (12) selektiv verschließbar ist.

12. System, umfassend einen Probenhalter (10) nach einem der vorhergehenden Ansprüche sowie ein Steuerungsgerät (3) zum Ansteuern des Aktuators (15).

13. Verfahren zur Verwendung eines Probenhalters (10), der einen Strömungskanal (12), eine erste Wandung (21), die einen Bereich (14) des Strömungskanals (12) begrenzt, sowie einen Aktuator (15) umfasst, das Verfahren umfassend Bewegen der ersten Wandung (21) mittels des Aktuators (15), um einen Querschnitt in dem Bereich (14) des Strömungskanals (12) zu beeinflussen.

14. Verfahren nach dem vorhergehenden Anspruch, wobei der Querschnitt beeinflusst wird, während eine im Probenhalter (10) befindliche Probe mit einem Elektronenstrahl beschossen wird und/oder während ein Medium durch den Bereich (14) des Strömungskanals (12) strömt.

15. Verfahren nach einem der zwei vorhergehenden Ansprüche, wobei durch wiederholte Verjüngung und Vergrößerung des Querschnitts eine Schwingung erzeugt wird.
